# EUROPEAN PATENT APPLICATION

(11) **EP 2 336 255 A1**
(43) Date of publication of application: **22.06.2011**
(21) Application number: 09179730.8
(22) Date of filing: 17.12.2009
(51) Int. Cl.: C09D 165/00, C08K 5/17, C09D 125/18, C09D 133/14, C09D 133/24, C09D 179/02, C08L 65/00

(54) **Organic electronics with improved stability and performance**

(71) Applicant: BASF SE, 67056 Ludwigshafen (DE)
(72) Inventor: Grigorenko, Nikolay A., 4056 Basel (CH); Mühlebaoh, Andreas, 5070 Friok (CH); Rime, François, 2800 Delémont (CH)
(74) Representative: Upschulte, Manfred Alois

(57) **Abstract**

Disclosed is a process for the preparation of an electronic device comprising a layer of a conductive (co)polymer or blend wherein anionic polysulfonate moieties are combined with cationic moieties selected from polythiophenes, polypyrroles and/or polyanilines, which process comprises addition of a tertiary amine to the aqueous solution or dispersion of the polymer's acidic form, and application of the thus neutralized polymer or polymer blend by a suitable method to form a layer. Especially advantageous for use in this process are conductive copolymers or blends of this class, which are water soluble, and whose anionic part is a copolymer combining sulfonic recurring structural units derived from vinylbenzenesulfonic, C₂-C₈alkenylsulfonic, (meth)acryloyloxy-C₂-C₈alkyl-sulfonic, (meth)acryloylamido-C₂-C₈alkyl-sulfonic acid or salts or mixtures thereof, with at least 10% b.w. recurring structural units of polyethylenglycol-acrylate and/or polyethylenglycol-methacrylate.

The devices based on conductive layers obtained according to the present method, as well as the conductive polymers and layers themselves, show improved durability and performance features.

## Description

The present invention relates to a method for obtaining certain conductive polymers having improved stability and performance, to electronic devices, especially organic light emitting diodes (OLEDs), containing these improved polymers, and to a novel polymer or polymer blend taking particular advantage of the present method.

Poly(3,4-ethylenedioxythiophene)-polystyrenesulfonate (PEDOT:PSS) is known as a hole injection and smoothening layer in many electronic devices like OLED (organic light emitting devices), OPV (organic photovoltaic), OFET (organic field effect transistors) and OPD (organic photodiodes). High acidity of the unmodified material (pH: ca. 2), just like in many other conductive polymers obtained from oxidative polymerization, lowers its intrinsic stability: In case of PEDOT:PSS, the regular storage time of the dispersions is thus limited, and low temperature storage may be required. Once applied, the dispersions may corrode other layers, with negative impact on the device's life time. Other conductive polymers obtained by oxidative coupling (mainly polypyrroles, polyanilines, other polythiophenes) usually are of similar structure, containing sulfonate/sulfonic acid moieties as dopant to counterbalance positive charges of the polymer obtained in the oxidative coupling reaction. The sulfonic part of these copolymers or blends usually provides an excess negative charge, the resulting material thus contains further cations (e.g. iron cations resulting from the oxidation reaction, or protons in case of the acidic form).

It has now been found that, while addition of neutralizing agents like alkali hydroxides often leads to an unacceptable decrease of device perfomance, the acidity of such conductive polymers may advantageously be lowered, if tertiary amines are used for the neutralization (typically to pH 4-7). The resulting layers comprising these neutralized polymers thus may avoid the shortcomings noted above. In general, device performance may thus be maintained while stability is improved and corrosiveness becomes reduced, both in the final device and before processing. In consequence, device lifetime and performance may increase considerably. In addition, the conductive particles may be handled (and in some cases applied) as dry powders and re-dispersed not only in water but also in dry organic solvents like DMA or methyl-cellosolve due to the more hydrophobic character of the neutralized material. The present devices comprising conductive polymers/nanoparticles neutralized with tert-amines show good storage stability and thermal stability, with no decomposition of the ammonium groups/no release of amines. Moreover, hygroscopic behaviour of certain coating layers (such as PEDOT:PSS) may be reduced.

The conductive polymers/particles may have a core/shell structure (as disclosed in WO09/112382) or consist of a soluble or dispersable co-polymer or blend with an excess of sulfonic acid groups, already partially neutralized by the doped conductive polymer selected from polythiophenes, polypyrroles or polyanilines. In a preferred embodiment, the conductive polymer is mainly based on polypyrrole (PPy). In another specific embodiment, the conductive polymer is based on poly(3,4-ethylene-dioxythiophene) (PEDOT), see http://www.clevios.com/index.php?page id=602.

First of all, the invention thus relates to the preparation of an electronic device comprising a layer of a conductive (co)polymer or blend wherein anionic polysulfonate moieties are combined with cationic moieties selected from polythiophenes, polypyrroles and/or polyanilines, which process comprises addition of a tertiary amine to the aqueous solution or dispersion of the polymer's acidic form, and application of the thus neutralized (co)polymer or blend by a suitable method to form a layer.

Preferred devices obtained by incorporation of such a layer include an organic field effect transistor, a solar cell, an organic light emitting diode, an organic photodiode, or a device comprising an organic field effect transistor, solar cell, organic light emitting diode (OLED) and/or organic photodiode. Especially preferred is a process for the preparation of an OLED.

The tertiary amine is usually added in an amount to reach pH 4 - 7; it may conveniently be added to the aqueous solution of the (co)polymer or blend. The neutralized solution or dispersion obtained may subsequently be dried, and optionally redissolved or dispersed in an organic solvent, especially of boiling point 50-180°C. The tertiary amine is preferably selected from amines of the formula NR₃, where R is selected from C₁-C₈alkyl, C₂-C₆alkyl substituted by OH or C₁-C₆alkoxy or di(C₂-C₆alkyl)amino-C₂-C₆alkyl, phenyl, benzyl, tolyl, especially from C₂-C₆alkyl such as ethyl, n-propyl, n-butyl. Advantageously, the aqueous solution or dispersion of the (co)polymer or (co)polymer blend is desalinated in an additional step prior to the neutralization step, which additional step may comprise ion exchange and/or dialysis.

As noted above, the final device usually contains the neutralized form of the conductive (co)polymer or blend in form of a layer; the method to form a layer often is selected from printing and spin-coating. Typical layer thickness is from the range 10 - 500 nm, especially 20-100 nm.

Many methods for the preparation of a conductive (co)polymer or blend containing anionic polysulfonate moieties combined with cationic moieties selected from polythiophenes, polypyrroles and/or polyanilines are known in the art. These methods often comprise oxidative polymerization of thiophenes, pyrroles or anilines in the presence of a polymer or copolymer containing sulfonic moieties SO₃X, where X stands for a radical suitable for dissociation as a cation; examples for such radicals are H, M, N(R₁)₄, wherein M stands for one equivalent of a metal, e.g. an alkali or alkaline earth metal or zinc, and R₁ independently stands for H or a C₁-C₂₀ hydrocarbon residue such as C₁-C₈alkyl; preferred cations are Li+, Na+ and especially H+, HN(C₂H₅)₃+, HN(C₄H₉)₃+ as further described in the present neutralization process. Examples for preferred monomers, which may be converted into suitable polymers or copolymers of this class, include acids along with their esters and salts selected from vinylbenzenesulfonic (i.e. styrene sulfonic), C₂-C₈alkenylsulfonic, (meth)acryloyloxy-C₂-C₈alkyl-sulfonic, (meth)acryloylamido-C₂-C₈alkyl-sulfonic derivatives.

In general, the invention comprises a water soluble polymer or copolymer, or a water dispersible polymer which may be in the form of nanoparticles. The polymer or copolymer contains sulfonate groups (preferred anionic monomers are styrene-sulfonates, sulfonato-alkyl-(meth)acrylates; preferred comonomers are (M)PEG-(meth)acrylates, alkyl- or aryl-(meth)acrylates, styrene), coated or mixed with the doped conductive polymer (such as PPy, polyaniline, PEDOT; preferred are PEDOT or especially PPy) and neutralized to pH 4-7 by addition of a tertiary amine. These tertiary amines are selected from tri-substituted amines (formula: NR₃), with substituents (R) preferably selected from alkyl, heteroalkyl, aryl, heteroaryl. Preferred examples are amines whose R is selected from C₁-C₈alkyl, C₂-C₆alkyl substituted by OH or C₁-C₆alkoxy or di(C₂-C₆alkyl)amino-C₂-C₆alkyl, phenyl, benzyl, tolyl, more preferred R is C₂-C₆alkyl, especially ethyl, n-propyl, n-butyl. Examples for preferred tertiary amines are triethyl-, tri-n-propyl and tri-n-butyl-amine.

Use of a certain group of copolymers is especially advantageous in the present process and for use as conductive layer. These are conductive copolymers of the above mentioned class, i.e. coated or mixed with the doped conductive polymer (such as PPy, polyaniline, PEDOT; preferred are PEDOT or especially PPy), whose anionic part is a copolymer comprising styrene sulfonate and at least 10% b.w. of a polyethylenglycol-acrylate or -methacrylate (both with free OH or methylated CH₃O end groups, als referred to as (M)PEG-(meth)acrylates). The water soluble conductive copolymers generally are linear or crosslinked, with Mn (uncoated, as determined by size exclusion chromatography SEC) usually ranging from about 10'000 to about 200'000 Da. The weight ratio of monomers styrene sulfonate : (M)PEG-(meth)acrylate thereinoften ranges from 9 : 1 to 3 : 7. Their preparation generally follows known procedures of emulsion polymerization. No addition of surfactant is required, whose addition is preferably avoided (preferably surfactant-free: no surfactant should be present in the final device layer).

The (M)PEG-(meth)acrylate to be used is preferably from the molecular weight of about 250 to about 4500 (about 4 to 100 PEG units), especially 300 to about 2500 (about 5 to 50 PEG units).

### (Co)Polymerization of the sulfonic part

Monomers providing anionic functionality are mainly those of formula

PG-Sp-Ra

wherein
PG stands for a polymerizable group, especially a vinyl group orhalovinyl group;
Ra is a residue providing anionic functionality selected from -SO₃X;
Sp is a direct bond or suitable spacer of valency (a+1) comprising 1 to about 50 carbon atoms, especially selected from alkylene, cycloalkylene and arylene groups and their combinations and such groups interrupted by oxygen or sulphur or nitrogen and/or substituted by O, S;
X is a radical suitable for dissociation as a cation; examples for such radicals are H, M, R₁, N(R₁)₄, wherein M stands for one equivalent of a metal, e.g. an alkali or alkaline earth metal or zinc, and R₁ independently stands for H or a C₁-C₂₀ hydrocarbon residue such as C₁-C₈alkyl, especially with styrene sulfonic acid or a suitable salt or ester thereof; preferred cations are Li+, Na+ and especially H+, HN(C₂H₅)₃+, HN(C₄H₉)₃+. Examples for preferred monomers of this class include acids along with their esters and salts selected from vinylbenzenesulfonic, C₂-C₈alkenylsulfonic, (meth)acryloyloxy-C₂-C₈alkyl-sulfonic,
(meth)acryloylamido-C₂-C₈alkyl-sulfonic, vinylbenzenephosphonic, C₂-C₈alkenylphosphonic, (meth)acryloyloxy-C₂-C₈alkyl-phosphonic, (meth)acryloylamido-C₂-C₈alkyl-phosphonic derivatives.
If esters are used, these are preferably converted into the corresponding anionic moieties (acids or especially salts) before carrying out the final step described below (deposition of the shell).

Examples for suitable anionic monomers or those convertible into anionic moieties include: 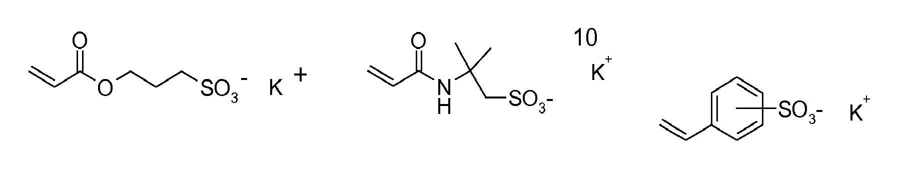 wherein potassium ions may also be replaced by other suitable cations such as sodium or H, the acryloyl residue may alternatively be replaced by methacryloyl.

If the sulfonic (co)polymer is particle-based, the grafting density of anionic chains on the particle surface often is from the range 0.001 to about 1 chain per nm².

Further monomers may be copolymerized (or attached to the particle core) in the same way; these comonomers may serve to adapt further properties of the final copolymer such as hydrophilicity/hydrophobicity, solution properties, electrostatic or steric properties. Basically, such further comonomers are chosen from the group disclosed in WO09/112382, provided that the dispersion medium is suitable as a solvent for the desired product. Preferred comonomers of this class include (meth)acrylic acid along with their salts and esters such as acrylates and methacrylates e.g. of (poly)ethyleneglycol, etherified poly(ethyleneglycol) or polyetheralcohols of various (poly)ether/polyglycol chain lengths (e.g. comprising 1-400, especially 2-100 monomer units); or divinylbenzene, butadiene for crosslinking.

The copolymerization reaction is preferably carried out in the liquid phase in presence of a polar solvent or dispersing phase. The reaction may be carried out as radical polymerization, preferably initiated by addition of a radical starter and/or application of heat and/or actinic radiation. In a typical reaction, an uncharged or charged core particle as described above is dispersed in a polar solvent. After addition of the monomer providing anionic functionality (preferably on 100 pbw of the core particle in an amount ranging from 1 pbw to about 10000 pbw) and further optional components such as comonomer(s), surfactant(s) etc., the copolymerization is initiated by application of heat (e.g. 50-100°C, inert gas, stirring) and/or addition of a polymerization initiator such as a radical starter.

Copolymerization reactions are carried out according to methods known per se, e.g. by addition of suitable monomers to the dispersion of core particles under conditions initiating the desired reaction. In case that ethylenically unsaturated monomers are used (especially those wherein PG stands for vinyl), the reaction may conveniently be initiated by addition of a radical starter.

The ratio of corona-forming monomer to core particle starting material (dry mass) often is from the range 0.02 : 1 to about 1000 : 1 (parts by weight).

Each of the copolymerization reactions may be carried out in presence of crosslinking agents such as monomers containing 2 or more vinyl moieties ("hydrogel corona"; examples: divinylbenzene, butadiene, di- or tri-(meth)acrylates, photo- or thermal degradable crosslinkers). The ratio of crosslinking agent, if present, to corona-forming monomer often ranges from 0 (no crosslinker) to about 0.05 : 1 (parts by weight).

The material obtained already contains negative charges on its surface; work-up may follow procedures known in the art including isolation and/or drying of the intermediate particles.

For example, a suitable monomer containing functional groups SO₃H, SO₃M or SO₃R₁, wherein M stands for one equivalent of a metal cation and R₁ stands for a C₁-C₂₀ hydrocarbon residue such as C₁-C₈alkyl, e.g. styrene sulfonic acid or a suitable salt or ester thereof, is polymerized or subjected to copolymerization with one or more further comonomers as described above,
and the sulfonic groups, especially SO₃H and SO₃R₁ if introduced, are optionally converted into SO₃M, especially SO₃Na, in a subsequent step.

The optional conversion of esters and/or acids into corresponding salts is usually effected by reaction (hydrolyzation) of the ester with a strong base, e.g. an alkaline hydroxyde such as aq. NaOH, which is usually applied as an aqueous solution with or without additional heating step.

### Deposition of cationic polymer

To the sulfonic polymer or copolymer obtained in the previous step, monomers may be added which are suitable for oxidation polymerization (also known as oxidative coupling). Polymerization with deposition of the corresponding oxidation polymer takes place after reaction with a suitable oxidant such as metal cations (especially iron(III)), peroxo compounds such as peracids, peroxodisulphates (e.g. ammoniumperoxodisulphate), H₂O₂. Solubility or dispersibility of the conductive copolymer or blend thus obtained is generally retained after this step, copolymers are still water soluble, particles are still redispersible.

For example, a pyrrole is polymerized in presence of the sulfonic (co)polymer or particle; which may be achieved by addition of e.g. 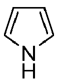 and a suitable oxidant such as an Fe(III) salt, FeCl₃, iron(III) tosylate. Further examples of suitable monomers for this step include aniline, thiophene, and substituted derivatives (with substituents e.g. selected from lower alkyl such as C₁-C₆alkyl) known to undergo oxidative polymerization.

The amount of oxidation polymer usually is at least 5 % by weight (e.g. 5-90% b.w., especially 5 to 30% b.w.) of the final conductive copolymer or blend.

In a preferred process, the solution or dispersion obtained after the above oxidation step is then subjected to desalination, e.g. by ultrafiltration.

### Definitions and general conditions

"Excess negative charge" on the particle refers to an amount of anionic groups which exceeds the one of cationic groups (if such cationic groups are present). In effect, the anionic groups on the surface dissociate from their counter cations in suitable environments.

Counter cations or "free cations" are cations which may dissociate from the anionic group, preferably selected from protons or especially alkali, ammonium or phosphonium cations. Where not stated otherwise, particle sizes are given as hydrodynamic radius (Rh, determined by dynamic light scattering (DLS)). Dry particle diameters are determined by TEM.

Polar liquids for use as solvents and/or dispersing medium, especially for preparing and/or (re)dispersing the conductive copolymers or blends, include water; alcohols including mono-, di- or polyhydric alcohols; ethers; esters; carboxylic acids and/or anhydrides; ketones; amides; amines; ionic liquids. Examples are water, ethanol, methanol, 1-propanol, 2-propanol, 1-butanol, 2-butanol, tert.-butanol, pentanol, cyclopentanol, cyclohexanol, glycol, glycerine, dimethylether, diethylether, methyl-butylether, furane, dioxane, tetrahydrofuran, acetone, methyl-ethyl-ketone, methyl-butyl-ketone, cyclopentanone, cyclohexanone, pyridine, piperidine etc. as well as mixtures thereof, or mixtures containing the polar solvent in admixture with a less polar cosolvent.

### Novel conductive polymers

In a preferred process of the invention, the conductive (co)polymer or blend has been obtained by oxidative polymerization of pyrrole, aniline or 3,4-ethylenedioxythiophene in presence of a sulfonic copolymer, which is water soluble. This sulfonic copolymer often contains at least 10% b.w. recurring structural units of polyethylenglycol-acrylate and/or polyethylenglycol-methacrylate; preferably it is a copolymer comprising 10 to 70 % b.w. of structural units derived from a polyethylenglycol-acrylate or polyethylenglycol-methacrylate having free or methylated end groups, and 10 to 90 % b.w. of structural units derived from vinylbenzenesulfonic (i.e. styrene sulfonic), C₂-C₈alkenylsulfonic, (meth)acryloyloxy-C₂-C₈alkyl-sulfonic, (meth)acryloylamido-C₂-C₈alkyl-sulfonic acid or salts or mixtures thereof. The sulfonic copolymer may comprise further structural units derived from other vinyl monomers as well as crosslinking oligomers such as styrenic, acrylic and methacrylic monomers, di- or tri(meth)acrylates, examples are styrene, C₁-C₄alkoxy-C₂-C₄alkyl-(meth)acrylate, hydroxy-C₂-C₄alkyl-(meth)acrylate, (meth)acrylic acid, dihydroxy-C₂-C₄alkylene-linked di(meth)acrylates such as ethyleneglycol-dimethacrylate. The amount of these comonomers may vary widely, for example, the final copolymer may contain up to 80 % b.w. of these structural units, for example 15-40%. The total amount of crosslinking units among them usually is 3% b.w. or lower and may be zero; preferred are 0.1 to about 1.5% b.w. of crosslinkers (all percentages in this section refer to the total weight of the sulfonic copolymer, prior to deposition of the cationic part).

Both the preparation of the water soluble sulfonic copolymer, and its conversion into the conductive copolymer or blend, is preferably accomplished without addition of a surfactant.

After deposition of the cationic polymer, the final conductive (co)polymer or blend has a molecular weight expressed by a number average Mn from the range 10'000 to 200'000 Da (determined by size exclusion chromatography).

The copolymers or blends thus obtained are novel compounds. The invention thus further relates to a conductive copolymer or blend comprising anionic polysulfonate moieties and cationic moieties selected from polythiophenes, polyanilines and/or polypyrroles, whose anionic part is a copolymer combining sulfonic recurring structural units derived from vinylbenzenesulfonic (i.e. styrene sulfonic), C₂-C₈alkenylsulfonic, (meth)acryloyloxy-C₂-C₈alkyl-sulfonic, (meth)acryloylamido-C₂-C₈alkyl-sulfonic acid or salts or mixtures thereof, with at least 10% b.w. recurring structural units of polyethylenglycol-acrylate and/or polyethylenglycol-methacrylate whose polyethylenglycol chains have free OH or alkylated, especially methylated, end groups. A preferred conductive copolymer or blend among this group is one whose cationic part is selected from poly(3,4-ethylenedioxythiophene), polyanilines or polypyrrole, especially polypyrrole, and whose anionic part is a copolymer comprising as monomer units
10 to 70 % b.w. of polyethylenglycol-acrylate and/or polyethylenglycol-methacrylate and
10 to 90 % b.w. of vinylbenzenesulfonic, C₂-C₈alkenylsulfonic, (meth)acryloyloxy-C₂-C₈alkylsulfonic, (meth)acryloylamido-C₂-C₈alkyl-sulfonic moieties, and optionally 0 - 80 % b.w. of further moieties as defined above.

The molecular weight Mn of these sulfonic copolymers (uncoated, i.e. prior to contacting with the polyaniline, polypyrrole or PEDOT) is preferably from the range 10'000 to 200'000 Da as determined by size exclusion chromatography. The final conductive copolymers or blends contain as cationic species balancing more than 1% of the total sulfonate charge exclusively those selected from the group consisting of the cationic polymer, H+, Fe2+, Fe3+, alkali+, Ca2+, Zn2+, Mg2+, Al3+ and ammonium. Especially preferred are these novel copolymers or blends in the tert.-amine neutralized form, wherein cationic species balancing more than 1%, especially more than 0.1 %, of the anionic charge are exclusively selected from the group consisting of the cationic polymer, and tertiary ammonium, where tertiary ammonium is most preferably HNR₃+ with R as defined above.

In order to obtain the present neutralized forms, the oxidatively polymerized materials are first subjected to a desalination step, e.g. by ultrafiltration. A further purification step advantageously lowers the remaining content of metal cations (including Na+, K+, Ca++, Zn++, Mg++, Al+++, Cr*, Fe*, which often are present as remainders of the previous synthesis; the asterisk [*] denotes that the ion may be present in more than one oxidation state, often 2+ or 3+); this purification may be accomplished e.g. by ion-exchange or dialysis, replaces metal ions by H+. The remaining content of any of the metal ions preferably is below 500 ppm, more preferably below 200 ppm, especially below 100 ppm.

The acidic form thus obtained is neutralized according to the present invention, generally to pH 4-7, by addition of the tertiary amine to the aqueous system as described above.

### Uses

The conductive polymers thus obtained are mainly used for OLEDs, OPVs (organic photovoltaics), OFETs (organic field effect transistors) and OPDs (organic photodiodes). Special emphasis is given to printable systems, e.g. formulations for printing inks, since these products allow simplified handling, storage and application of the required printing inks, pastes or toners. Special emphasis is also given to OLEDs, especially printable OLEDs. A typical utility of the present polymers is the smoothening layer between indium-tinoxide (ITO) electrode and further device layers. Especially useful as smoothening layer are those copolymers comprising 10% b.w. or more of structural moieties resulting from copolymerization with polyethylenglycol-(meth)acrylate as described above, more especially the water soluble materials based on sulfonic copolymers of molecular weight Mn from the range 10000 to 200000 obtained in this way.

The conductive materials may be used in the electronic device of the invention as conductor material, conductor- or semiconductor-precursor, in capacitor applications, e.g. in optical or acustic filters, electronic devices or light managing systems. For example, the present materials may be contained or form the main constituent of the hole injection layer in an OLED device. A further important application is the replacement of ITO, which is widely used mainly as an electrode material at present. Further electric or electronic devices, where the present materials may be used, thus include integrated circuits, displays, RFID tags, electro- or photoluminescent devices, backlights of a display, photovoltaic or sensor devices such as solar cells, charge injection layer, planarising layers, antistatics, conductive substrate or patterns, photoconductors, or electrophotographic applications or recording materials.

In an important application, the present materials are used for the formation of conducting or semiconducting layers. For this, conductive copolymers or blends as described above are applied to the substrate in a conventional manner, e.g. by application of the dry materials or especially by a coating or printing technique using the materials dissolved or dispersed in a suitable solvent (e.g. water, alcohol or mixtures thereof) and drying. The conductive or semiconductive layer is then conveniently obtained by drying, with or without application of heat and/or pressure (see application methods described in WO09/112382, WO09/077349).

Typical temperatures for conversion into a layer are in the range 20-250°C, e.g. 80-200°C. In case that the particle is applied by a printing process with application of (unidirectional) pressure (e.g. in xerographic printing/laser printing, or a transfer printing or compression bonding process as of US-7105462 or US-7176052), the combination of pressure and temperature may result in more homogenous layers obtained at lower conversion temperatures.

The invention thus includes electronic devices or optical or acustical filters comprising one or more types of materials as described above and/or a conductive or semiconductive layer obtained by application of the materials as described above.

The present particles may also be used as such in inks (i.e. as a dye or pigment), especially as or conductive ink. Some of the uses are explained in more detail in the below examples.

The following test methods and examples are for illustrative purposes only and are not to be construed to limit the instant invention in any manner whatsoever. Room temperature (R.T.) depicts a temperature in the range 20-25°C; over night denotes a time period in the range 12-16 hours. Percentages and ratios in the examples and elsewhere are by weight unless otherwise indicated.

Abbreviations used in the examples or elsewhere:
- AIBN: Azobisisobutyronitrile
- AFM: atomic force microscopy
- (co)polymer: polymer or copolymer
- DLS: dynamic light scattering
- (meth)acrylic: acrylic or methacrylic
- OLED: Organic Light Emitting Diode
- SDS: sodiumdodecylsulfat
- GPC: gel permeation chromatography
- THF: tetrahydrofuran
- PS: polystyrene
- SSEE: styrene sulfonate ethyl ester
- PSS: polystyrenesulfonate
- PEGMA: poly (ethylene glycol) methacrylate methyl ether
- PPy: polypyrrole
- PEDOT: poly(3,4-ethylenedioxythiophene)
- DVB: divinyl benzene
- PDI: polydispersivity
- SEC: size exclusion chromatography
- TEM: transmission electron microscopy
- pbw: parts by weight
- TOSOH: stands for the supplier Tosoh Corp., Tokyo (JP)
- ITO: indium doped tin oxide
- FTO: fluorine doped tin oxide
- UF: ultrafiltration.

### Examples A: Preparation of Starting Materials and of Conductive Polymers (acidic form)

### Example 1 : Slightly crosslinked polystyrene core particle

5 g Sodiumdodecylsulfat (SDS, Fluka techn.) and 500 ml water are introduced in a 1 L round bottom flask with mechanical stirring, and purged with nitrogen during 15 min. After heating to 55°C with an oil bath, a first portion of 0.25 g potassiumperoxodisulfate (KPS, Fluka microselect), dissolved in 6 ml water is introduced. The monomer mixture consisting of 21 g (201.6 mmol) styrene (Fluka purum), 25 g (195.1 mmol) n-butyl acrylate Fluka purum) and 4.0 g (31.7 mmol) allyl-methacrylate (Fluka purum) is added slowly during 8 h while maintaining the emulsion at 55°C and the stirring speed at 300 rpm. 3 h after the start of the monomer addition, a second portion of 0.25 g potassiumperoxodisulfate (KPS, Fluka microselect), dissolved in 6 ml water is added. After the addition of all monomer the reaction is continued for 14 h at 55°C and then cooled to R.T. 576.6 g of white latex is obtained.

### Analytics:

DSC (10°C/min.): Tg=30°C
Dynamic light scattering (DLS): Average diameter (z-average): 28.4 nm.

Example 2 : Core/shell nanoparticle with slightly crosslinked poly(sodium 4-vinylbenzene sulfonate/PEG-acrylate) first shell ("corona").

In a 1 L round bottom flask with mechanical stirring, 41.4 g of the emulsion (corresponding to 3 g solid material) of the core particles of Ex. 1 is diluted with 200 ml water and purged with nitrogen during 2 h. The mixture is stirred with 300 rpm under N₂, heated with an oil bath to 70°C and 1.5 g (11.5 mmol) divinylbenzene (Fluka techn.), 1.5 g (11.7 mmol) n-butyl acrylate (Fluka purum) and 40 mg potassiumperoxodisulfate (KPS, Fluka microselect) dissoved in 3 ml water added with a syringe through a septum. The mixture is stirred at 70°C for 30 min. Two monomer solutions are prepared:
A) 20.61 g (90 mmol) 4-vinylbenzene-sulfonic acid sodium salt (Fluka techn., 90%), 0.18 g (0.95 mmol) ethylene-glycol dimethacrylate (EDMA, Fluka, purum) in 100 ml water and
B) 6.67 g (42.2 mmol) 2-ethoxyethyl methacrylate (EEMA, Aldrich 99%), 0.18 g (0.95 mmol) ethylene-glycol dimethacrylate (EDMA, Fluka, purum) and 6.67 g (14.7 mmol) poly(ethylene glycol) methylether acrylate (M-PEG-A, Aldrich, Mn=454)

A solution of 80 mg potassiumperoxodisulfate (KPS, Fluka microselect) dissoved in 6 ml water is now added to the reaction mixture (temperature at 70°C) followed by continuous addition of the solutions A) and B) with 2 separate pumps during 4 h. After the addition of all monomers, another portion of 40 mg potassiumperoxodisulfate (KPS, Fluka microselect) dissoved in 3 ml water is added and the reaction continued at 95°C overnight (=postreaction).

After cooling to R.T., 444.4 g of a white latex is obtained. One third of this amount is ultrafiltrated in a Amicon® cell with a polyethersulfone membrane (diameter 76 mm, cut-off: 300'000 Da, p=5 bar) until a total permeate quantity of 500 ml is reached. The purified dispersion is then freeze-dried and 11.47 g solid powder obtained. Therefore, the solid content of the dispersion is calculated to be 7.7%, giving a total solid content of 34.4 g. The total monomer conversion can thus be calculated to be 88%.

Analytics: Elemental analysis; calc. % (found %): S 7.13 (6.89).

Transmission electron microscopy (TEM): Average diameter d=40 nm.

### Example 3 : Synthesis of conductive (polypyrrole coated) core/shell nanoparticle

65.5 g of the core shell particle dispersion of Ex. 2 (5.04 g solid material) is diluted with 250 ml water in a 750 ml round bottom flask with mechanical stirring and degazed by purging with Ar for 1 h. 1.81 g (27 mmol) pyrrole (Fluka purum, distilled) is added and the mixture stirred with 300 rpm under Ar at R.T. 42.07 g (62.1 mmol) iron(III)tosylate-hexahydrate (Aldrich, techn.) dissoved in 175 ml water, degazed and purged with Ar before, is continuously added with a pump during 30 min. Thereafter, the reaction mixture is kept under Ar and stirring for another 2 h at R.T.

Purification and work-up:
1. Ultrafiltration (UF) in two VivaFlow® cells with polyethersulfone membranes (cut-off: 100'000 Da), total permeate quantity: 3x800 ml.
2. Removal of iron salts: Oxydation of all Fe(II) to Fe(III) by addition of 0.92 g H₂O₂ (Fluka, 30%), diluted in 10 ml water, and stirring 1 h at R.T. followed by the addition of 54.2 ml of a 0.1 M solution of ethylenediamine-tetraacetic acid (EDTA) disodium salt dihydrate (Aldrich), stirring for 45 min. and ultrafiltration in two VivaFlow® cells with cellulose membranes (cut-off: 100'000 Da), total permeate quantity: 3x800 ml.
3. Removal of sodium salt: The dispersion is diluted with water by 50%. The ion exchange is done on a column filled with acidic (H⁺) Amberlite 120 resin (Fluka), 100 ml, with a flow of 2 ml/min, followed by re-concentration of the dispersion by UF to a solid content of 5.6%. A sample is freeze-dried for analytics:
   Elemental analysis; found % (calc. %): N 4.78 (5.52), S 5.94, Fe 69 mg/kg, Na 152 mg/kg.
   Polypyrrole content (calculated from elemental analysis): 23%.

Transmission electron microscopy (TEM): Average diameter d=40 nm.

DC conductivity of compressed powder (4-point measurement): 0.2 S/cm.

The black powder is re-dispersed in water to obtain dispersions of 2 and 4 % and also re-dispersed in dry N,N-diemthyl-acetamide (DMA) to obtain a dispersion of 2.5% in this organic solvent.

Film properties: Films are prepared by spin-coating using the spin coater of Headway Research. Inc.. The particle concentration is 2 % (w/w). The spin speed is adjusted to obtain a desired film thickness, which is measured by a TENCOR^{®} P-10 surface profiler. The surface quality of these colloidal films is checked by tapping mode atomic force microscopy (AFM), Dimension 3100 close loop (Digital instrument Veeco metrology group).
AFM roughness (Rq) = 16 nm.

### Example 4 : Synthesis of conductive (polypyrrole coated) core/shell nanoparticle with lower polypyrrole content.

In analogy to Ex. 3, 30 g of the core shell particle dispersion of Ex. 2 (2.31 g solid material) is diluted with 100 ml water in a 350 ml round bottom flask with mechanical stirring, degazed and purged with Ar. 0.305 g (4.56 mmol) pyrrole (distilled) is added and the mixture stirred with 300 rpm under Ar at R.T. 7.1 g (10.48 mmol) iron(III)tosylate-hexahydrate dissoved in 30 ml water (degazed and purged with Ar) is continuously added with a pump during 30 min. Thereafter, the reaction mixture is stirred for another 2 h at R.T.

Purification and work-up:
1. Ultrafiltration (UF) in VivaFlow® cell with polyethersulfone membrane, total permeate quantity: 3x275 ml.
2. Removal of iron salts: Oxydation of all Fe(II) to Fe(III) by addition of 0.12 g H₂O₂ (Fluka, 30%), diluted in 10 ml water, and stirring 1 h at R.T. followed by the addition of 7 ml of a 0.1 M solution of ethylenediamine-tetraacetic acid (EDTA) disodium salt dihydrate (Fluka), stirring for 45 min. and ultrafiltration in a VivaFlow® cells with polyethersulfone membrane, total permeate quantity: 3x275 ml.
3. Removal of sodium salt: The dispersion is ion exchanged on acidic (H⁺) Amberlite 120 resin column, 150 ml, with a flow of 1-2 ml/min, followed by re-concentration of the dispersion by UF to a solid content of 4.7%. A sample is freeze-dried for analytics:
   Elemental analysis; found %: N 2.29, S 5.96, Fe 17 mg/kg, Na 194 mg/kg.
   Polypyrrole content (calculated from elemental analysis): 10.96%.
   Transmission electron microscopy (TEM): Average diameter d=40 nm.

The black powder is re-dispersed in water to obtain a dispersion of 3 %. It is also redispersible in N,N-diemthyl-acetamide (DMA).

### Example 5: Core/shell nanoparticle with lower (anionic) charge density of the "corona", i.e. lower poly(sodium 4-vinylbenzene sulfonate) content in the first shell (in comparison to Ex. 2) In a 1 L round bottom flask with mechanical stirring, 41.4 g of the emulsion (corresponding to 3 g solid material) of the core particles of Ex. 1 is diluted with 200 ml water and purged with nitrogen during 2 h. The mixture is stirred with 300 rpm under N₂, heated with an oil bath to 70°C and 1.5 g (11.5 mmol) divinylbenzene, 1.5 g (11.7 mmol) n-butyl acrylate and 40 mg potassiumperoxodisulfate (KPS, Fluka microselect) dissoved in 3 ml water added with a syringe through a septum. The mixture is stirred at 70°C for 30 min. Two monomer solutions are prepared:

A) 12.38 g (60.04 mmol) 4-vinylbenzene-sulfonic acid sodium salt (Fluka techn., 90%), 0.12 g (0.63 mmol) ethylene-glycol dimethacrylate (EDMA) in 100 ml water and
B) 10.37 g (65.6 mmol) 2-ethoxyethyl methacrylate (EEMA), 0.41 g (2.16 mmol) ethylene-glycol dimethacrylate (EDMA) and 10.37 g (22.8 mmol) poly(ethylene glycol) methylether acrylate (M-PEG-A, Mn=454)

A solution of 80 mg potassiumperoxodisulfate (KPS) dissoved in 6 ml water is now added to the reaction mixture (temperature at 70°C) followed by continuous addition of the solutions A) and B) with 2 separate pumps during 4 h. After the addition of all monomers, another portion of 40 mg potassiumperoxodisulfate (KPS) dissoved in 3 ml water is added and the reaction continued at 95°C overnight (=postreaction).

After cooling to R.T., 457.7 g of a white latex is obtained. One third of this amount is ultrafiltrated in a Amicon® cell with a polyethersulfone membrane (diameter 76 mm, cut-off: 300'000 Da, p=2.5 bar) until a total permeate quantity of 500 ml is reached. The purified dispersion is then freeze-dried and 11.72 g solid powder obtained. Therefore, the solid content of the dispersion is calculated to be 7.7%, giving a total solid content of 35.2 g. The total monomer conversion can thus be calculated to be 87%.

Analytics: Elemental analysis; calc. % (found %): S 4.85 (4.67).

Transmission electron microscopy (TEM): Average diameter d=35 nm.

### Example 6 : Synthesis of conductive (polypyrrole coated) core/shell nanoparticle on corona with lower (anionic) charge density and lower polypyrrole content.

79.5 g of the core shell particle dispersion of Ex. 5 (6.12 g solid material) is diluted with 200 ml water in a 750 ml round bottom flask with mechanical stirring and degazed by purging with Ar for 1 h. 1.50 g (22.3 mmol) pyrrole (distilled) is added and the mixture stirred with 300 rpm under Ar at R.T. 34.79 g (51.36 mmol) iron(III)tosylate-hexahydrate (Aldrich, techn.) dissoved in 100 ml water, degazed and purged with Ar before, is continuously added with a pump during 30 min. Thereafter, the reaction mixture is kept under Ar and stirred overnight. Purification and work-up:
1. Ultrafiltration (UF) in two VivaFlow® cells with polyethersulfone membranes (cut-off: 100'000 Da), total permeate quantity: 3x800 ml.
2. Removal of iron salts: Oxydation of all Fe(II) to Fe(III) by addition of 0.83 g H₂O₂ (30%), diluted in 10 ml water, and stirring 1 h at R.T. in an ultrasound bath followed by the addition of 48 ml of a 0.1 M solution of ethylenediamine-tetraacetic acid (EDTA) disodium salt dihydrate (Fluka), stirring for 2 h and ultrafiltration in two VivaFlow® cells with polyethersulfone membranes (cut-off: 100'000 Da), total permeate quantity: 3x700 ml.
3. Removal of sodium salt: The ion exchange is done on a column filled with acidic (H⁺) Amberlite 120 resin (100 ml) with a flow of 1 ml/min, followed by re-concentration of the dispersion by UF to a solid content of 6.8%. A sample is freeze-dried for analytics:
   Elemental analysis; found %: N 3.78, S 4.04, Na 0.2, Fe 60 mg/kg.
   Polypyrrole content (calculated from elemental analysis): 18%.
   Transmission electron microscopy (TEM): Average diameter d=40 nm.

The black powder is re-dispersed in water to obtain dispersions of 2 and 4 % and also re-dispersed in dry N,N-diemthyl-acetamide (DMA) to obtain a dispersion of 2.5% in this organic solvent.

### Example 7: Core/shell nanoparticle with even lower (anionic) charge density of the "corona", i.e. lower poly(sodium 4-vinylbenzene sulfonate) content in the first shell (in comparison to Ex. 5)

In a 750 ml round bottom flask with mechanical stirring, 41.4 g of the emulsion (corresponding to 3 g solid material) of the core particles of **Ex. 1** is diluted with 200 ml water and purged with nitrogen during 2 h. The mixture is stirred with 300 rpm under N₂, heated with an oil bath to 70°C and 1.5 g (11.5 mmol) divinylbenzene, 1.5 g (11.7 mmol) n-butyl acrylate and 40 mg potassiumperoxodisulfate (KPS, Fluka microselect) dissoved in 3 ml water added with a syringe through a septum. The mixture is stirred at 70°C for 30 min. Two monomer solutions are prepared:
A) 6.91 g (30.2 mmol) 4-vinylbenzene-sulfonic acid sodium salt (Fluka techn., 90%), 0.062 g (0.33 mmol) ethylene-glycol dimethacrylate (EDMA) in 50 ml water and
B) 13.45 g (85 mmol) 2-ethoxyethyl methacrylate (EEMA), 0.54 g (2.84 mmol) ethylene-glycol dimethacrylate (EDMA) and 13.45 g (29.6 mmol) poly(ethylene glycol) methylether acrylate (M-PEG-A, Mn=454)

A solution of 80 mg potassiumperoxodisulfate (KPS) dissoved in 6 ml water is now added to the reaction mixture (temperature at 70°C) followed by continuous addition of the solutions A) and B) with 2 separate pumps during 4 h. After the addition of all monomers, another portion of 40 mg potassiumperoxodisulfate (KPS) dissoved in 3 ml water is added and the reaction continued at 95°C overnight (=postreaction).

After cooling to R.T., 388 g of a white latex is obtained. One third of this amount is ultrafiltrated in a Amicon® cell with a polyethersulfone membrane (diameter 76 mm, cut-off: 300'000 Da, p=2.5 bar) until a total permeate quantity of 500 ml is reached. The purified dispersion is then freeze-dried and 11.09 g solid powder obtained. Therefore, the solid content of the dispersion is calculated to be 8.6%, giving a total solid content of 33.3 g. The total monomer conversion can thus be calculated to be 81%.

Analytics: Elemental analysis; calc. % (found %): S 2.43 (2.33).

Transmission electron microscopy (TEM): Average diameter d=30 nm.

### Example 8 : Synthesis of conductive (polypyrrole coated) core/shell nanoparticle on corona with lower (anionic) charge density and lower polypyrrole content

66.3 g of the core shell particle dispersion of Ex. 7 (5.7 g solid material) is diluted with 200 ml water in a 750 ml round bottom flask with mechanical stirring and degazed by purging with Ar for 1 h. 0.696 g (10.38 mmol) pyrrole (distilled) is added and the mixture stirred with 300 rpm under Ar at R.T. 16.17 g (23.86 mmol) iron(III)tosylate-hexahydrate (Aldrich, techn.) dissoved in 100 ml water, degazed and purged with Ar before, is continuously added with a pump during 30 min. Thereafter, the reaction mixture is kept under Ar and stirred overnight. Purification and work-up:
1. Ultrafiltration (UF) in two VivaFlow® cells with polyethersulfone membranes (cut-off: 100'000 Da), total permeate quantity: 3x800 ml.
2. Removal of iron salts: Oxydation of all Fe(II) to Fe(III) by addition of 0.37 g H₂O₂ (30%), diluted in 10 ml water, and stirring 1 h at R.T. in an ultrasound bath followed by the addition of 21.5 ml of a 0.1 M solution of ethylenediamine-tetraacetic acid (EDTA) disodium salt dihydrate (Aldrich), stirring for 2 h and ultrafiltration in two VivaFlow® cells with cellulose membranes (cut-off: 100'000 Da), total permeate quantity: 3x800 ml.
3. Removal of sodium salt: The ion exchange is done on a column filled with acidic (H⁺) Amberlite 120 resin (100 ml) with a flow of 1 ml/min, followed by re-concentration of the dispersion by UF to a solid content of 8.8%. A sample is freeze-dried for analytics:
   Elemental analysis; found %: N 2.00, S 2.33, Na 0.1, Fe 60 mg/kg.
   Polypyrrole content (calculated from elemental analysis): 9.6%.
   Transmission electron microscopy (TEM): Average diameter d=40 nm.

The black powder is re-dispersed in water to obtain dispersions of 2 and 4 % and also re-dispersed in dry methyl-cellosolve (2-methoxy-ethanol) to obtain a dispersion of 2.4% in this organic solvent.

### Example 9 Synthesis of "shell only" co-polymer (polyelectrolyte) with anionic charge on the surface

In a 750 ml round bottom flask with mechanical stirring, 100 ml water is purged with nitrogen during 2 h, stirred with 300 rpm and heated with an oil bath to 70°C. Two monomer solutions are prepared meanwhile:
A) 18.55 g (90 mmol) 4-vinylbenzene-sulfonic acid sodium salt (Fluka techn., 90%), 0.18 g (0.95 mmol) ethylene-glycol dimethacrylate (EDMA) in 100 ml water and
B) 6.67 g (42.2 mmol) 2-ethoxyethyl methacrylate (EEMA), 0.27 g (1.4 mmol) ethylene-glycol dimethacrylate (EDMA) and 6.67 g (14.7 mmol) poly(ethylene glycol) methylether acrylate (M-PEG-A, Mn=454)

A solution of 80 mg potassiumperoxodisulfate (KPS) dissoved in 6 ml water is now added (with a syringe through a septum) to the reaction mixture (temperature at 70°C) followed by continuous addition of the solutions A) and B) with 2 separate pumps during 4 h. 2 h after starting the addition of the monomers the solution becomes slightly opaque. After the addition of all monomers, another portion of 40 mg potassiumperoxodisulfate (KPS) dissoved in 3 ml water is added and the reaction continued at 95°C overnight (=postreaction).

After cooling to R.T., the mixture is centrifuged (20 min. 3000 rpm) and the sedimented white solid discarded (ca. 3 g). The solution is filtered through glass fibers. Since the polymer goes completely through the polyethersulfone membrane (diameter 76 mm, cut-off: 300'000 Da, p=2.5 bar) in the Omicon® cell, the solution is concentrated in the rotavap and freeze-dried. 26.6 g of white solid is obtained; monomer conversion: ca. 97%. A 6% solution of this polymer in water is prepared.

Analytics: Elemental analysis of dry material; calc. % (found %): S 8.9 (9.38).

Size exclusion chromatography (SEC) (THF, absolute calibration with viscosity detector): Mₙ=75'200, M_{w}=163'300, M_{w}/Mₙ=2.17.

### Example 10 : Synthesis of conductive (polypyrrole coated) "shell only" polymer

40 g of the polymer solution of Ex. 9 (2.4 g solid material) is diluted with 200 ml water in a 750 ml round bottom flask with mechanical stirring and degazed by purging with Ar for 1 h. 1.18 g (17.6 mmol) pyrrole (distilled) is added and the mixture stirred with 300 rpm under Ar at R.T. 27.42 g (40.48 mmol) iron(III)tosylate-hexahydrate (Aldrich, techn.) dissoved in 100 ml water, degazed and purged with Ar before, is continuously added with a pump during 45 min. Thereafter, the reaction mixture is kept under Ar and stirred for 2 h.

### Purification and work-up:

1. Ultrafiltration (UF) in a Amicon® cell with a polyethersulfone membrane (diameter 76 mm, cut-off: 300'000 Da, p=2.5 bar) until a total permeate quantity of 4x300 ml.
2. Removal of iron salts: Oxydation of all Fe(II) to Fe(III) by addition of 0.52 g H₂O₂ (30%), diluted in 5 ml water, and stirring 1 h at R.T. in an ultrasound bath followed by the addition of 30.8 ml of a 0.1 M solution of ethylenediamine-tetraacetic acid (EDTA) disodium salt dihydrate (Fluka), stirring for 2 h and ultrafiltration in two VivaFlow® cells with polyethersulfone membranes (cut-off: 100'000 Da), total permeate quantity: 4x300 ml.
3. Removal of sodium salt: The ion exchange is done in diluted solution/dispersion (total volume: 400 ml) on acidic (H⁺) Amberlite 120 resin (180 ml), followed by filtration and re-concentration of the dispersion by UF to a solid content of 3.0%. A sample is freeze-dried for analytics: Elemental analysis; calc. % (found %): N 7.18 (6.34), S 6.59 (6.99); Na 182 mg/kg (found), Fe 40 mg/kg (found).
   Polypyrrole content (calculated from elemental analysis): 30%.

### Example 10a : Synthesis of conductive (polypyrrole coated) "shell only" polymer (similar to Ex. 10).

40 g of the polymer solution of Ex. 9 (2.4 g solid material) is diluted with 360 ml water in a 750 ml round bottom flask with mechanical stirring and degassed by purging with Ar for 1 h. 2.37 g (35.3 mmol) pyrrole (distilled) is added and the mixture stirred with 300 rpm under Ar at R.T. 13.36 g (40.6 mmol) potassium-hexacyanoferrat(III) (Pluka, puriss p.a.) dissoved in 100 ml water, degazed and purged with Ar before, is continuously added with a pump during 45 min. Thereafter, the reaction mixture is kept under Ar and stirred for 2 h.

Purification and work-up:
1. Ultrafiltration (UF) in flow cell with a polyethersulfone membrane (diameter 76 mm, cut-off: 30'000 Da, p=2.5 bar) until a total permeate quantity of 12x300 ml.

The ultrafiltrated product has a pH of 2.7 (H⁺-form) and a solid content of 2.5 %.

### Example 11 : Synthesis of conductive (polypyrrole coated) "shell only" polymer with lower polypyrrole content.

40 g of the polymer solution of Ex. 9 (2.4 g solid material) is diluted with 200 ml water in a 750 ml round bottom flask with mechanical stirring and degazed by purging with Ar for 1 h. 0.395 g (5.9 mmol) pyrrole (distilled) is added and the mixture stirred with 300 rpm under Ar at R.T. 9.19 g (13.57 mmol) iron(III)tosylate-hexahydrate (Aldrich, techn.) dissoved in 30 ml water, degazed and purged with Ar before, is continuously added with a pump during 1 h. Thereafter, the reaction mixture is kept under Ar and stirred for 2 h.

Purification and work-up:
1. Ultrafiltration (UF) in a Amicon® cell with a polyethersulfone membrane (diameter 76 mm, cut-off: 300'000 Da, p=2.5 bar) until a total permeate quantity of 3x300 ml.
2. Removal of iron salts: Oxydation of all Fe(II) to Fe(III) by addition of 0.14 g H₂O₂ (30%), diluted in 5 ml water, and stirring 1 h at R.T. in an ultrasound bath followed by the addition of 8 ml of a 0.1 M solution of ethylenediamine-tetraacetic acid (EDTA) disodium salt dihydrate (Fluka), stirring for 2 h and ultrafiltration in two VivaFlow® cells with polyethersulfone membranes (cut-off: 100'000 Da), total permeate quantity: 3x100 ml.
3. Removal of sodium salt: The ion exchange is done in diluted solution/dispersion (total volume: 500 ml) on acidic (H⁺) Amberlite 120 resin (150 ml), followed by filtration and re-concentration of the dispersion by UF to a solid content of 3.14%. A sample is freeze-dried for analytics: Elemental analysis; found %: N 2.54, S 8.38; Na 256 mg/kg, Fe 52 mg/kg. Polypyrrole content (calculated from elemental analysis): 12.1%.

### Example 12 : Synthesis of conductive coated) "shell only" polymer with poly(3,4-ethylene-dioxythiophene) (EDOT) instead of polypyrrole

40 g of the polymer solution of Ex. 9 (2.4 g solid material) is diluted with 100 ml water in a 350 ml round bottom flask with mechanical stirring and degazed by purging with Ar for 1 h. 0.358 g (2.52 mmol) 3,4-ethylene-dioxythiophene (Aldrich) is added with a syringe through a septum and the mixture stirred with 300 rpm under Ar at R.T. 9.6 mg iron(III)sulfate (Fluka) dissolved in 1.67 ml degazed and Ar purged water is added followed by 1.09 g (4.79 mmol) ammonium-peroxo-disulfate (Merck). Thereafter, the reaction mixture is kept under Ar and stirred overnight (17 h).

Purification and work-up:
8.9 g Lewatit MonoPlus S-100 (strongly acidic cation exchange resin from Fluka) is added to the reaction mixture and stirred for 5 h at R.T. After filtration, 8.9 g Lewatit MP-62 (weakly basic anion exchange resin from Fluka) is added to the reaction mixture and stirred for 5 h at R.T. After filtration, the reaction mixture is concentrated in the ultrafiltration (UF) cell Amicon® with a regenerated cellulose membrane (diameter 76 mm, cut-off: 10'000 Da, p=2.5 bar) to obtain a solid concentration of 3.0%: 65.07 g of a black dispersion is obtained. Elemental analysis (after freeze-drying); found %: S 9.71; Na 4.81.

In order to obtain the acidic form (H⁺) ion exchange is done with the water diluted dispersion on acidic (H⁺) Amberlite IR-120 resin (200 ml), followed by filtration and re-concentration of the dispersion by UF to a solid content of 3%: 36 g, pH=1.45.

A sample is freeze-dried for analytics:
Elemental analysis; found %: S 10.18; Na 270 mg/kg.
PEDOT content (calc.): 12.9%.

### Example 13 : Core/shell nanoparticles with slightly crosslinked first shell ("corona") of poly(potassium-3-sulfopropyl-methacrylate/PEG-acrylate) (instead of poly(sodium-4-vinylbenzene-sulfonate/PEG-acrylate)).

In a 1 L round bottom flask with mechanical stirring, 41.4 g of the emulsion (corresponding to 3 g solid material) of the core particles of **Ex. 1** is diluted with 200 ml water and purged with nitrogen during 2 h. The mixture is stirred with 300 rpm under N₂, heated with an oil bath to 70°C and 1.5 g (11.5 mmol) divinylbenzene (Fluka techn.), 1.5 g (11.7 mmol) n-butyl acrylate (Fluka purum) and 40 mg potassiumperoxodisulfate (KPS, Fluka microselect) dissoved in 3 ml water added with a syringe through a septum. The mixture is stirred at 70°C for 30 min. Two monomer solutions are prepared:
A) 18.55 g (75.3 mmol) potassium-3-sulfopropyl-methacrylate (Aldrich, 98%), 0.18 g (0.95 mmol) ethylene-glycol dimethacrylate (EDMA, Fluka, purum) in 100 ml water and
B) 6.67 g (42.2 mmol) 2-ethoxyethyl methacrylate (EEMA, Aldrich 99%), 0.27 g (1.43 mmol) ethylene-glycol dimethacrylate (EDMA, Fluka, purum) and 6.67 g (14.7 mmol) poly(ethylene glycol) methylether acrylate (M-PEG-A, Aldrich, Mn=454)

A solution of 80 mg potassiumperoxodisulfate (KPS, Fluka microselect) dissoved in 6 ml water is now added to the reaction mixture (temperature at 70°C) followed by continuous addition of the solutions A) and B) with 2 separate pumps during 4 h. After the addition of all monomers, another portion of 40 mg potassiumperoxodisulfate (KPS, Fluka microselect) dissoved in 3 ml water is added and the reaction continued at 95°C overnight (=postreaction).

After cooling to R.T., 445.3 g of a white latex is obtained. One third of this amount is ultrafiltrated in a Amicon® cell with a polyethersulfone membrane (diameter 76 mm, cut-off: 300'000 Da, p=2.5 bar) until a total permeate quantity of 500 ml is reached. The purified dispersion is then freeze-dried and 10.37 g solid powder obtained. Therefore, the solid content of the dispersion is calculated to be 7.0%, giving a total solid content of 31.1 g. The total monomer conversion can thus be calculated to be 78%.

Analytics: Elemental analysis; calc. % (found %): S 6.29 (5.71).

Transmission electron microscopy (TEM): Average diameter d=28 nm.

### Example 14 : Synthesis of conductive (polypyrrole coated) core/shell nanoparticles with propylsulfonate (instead of benzene sulfonate) in the shell.

20 g of the polymer solution of Ex. 13 (1.17 g solid material) is diluted with 200 ml water in a 750 ml round bottom flask with mechanical stirring and degazed by purging with Ar for 1 h. 0.35 g (5.22 mmol) pyrrole (distilled) is added and the mixture stirred with 300 rpm under Ar at R.T. 8.13 g (12 mmol) iron(III)tosylate-hexahydrate (Aldrich, techn.) dissoved in 40 ml water, degazed and purged with Ar before, is continuously added with a pump during 30 min. Thereafter, the reaction mixture is kept under Ar and stirred overnight.

Purification and work-up: Ultrafiltration (UF) in VivaFlow® cell with polyethersulfone membranes (cut-off: 100'000 Da), total permeate quantity: 3x250 ml: 123.13 g of a black dispersion is obtained with a solid content of 1.25%.

Analytics:
Elemental analysis; calc % (found %): N 4.79 (4.15), S 4.39 (5.36).
Polypyrrole content (calculated from elemental analysis): 19.9%
TEM: d=40 nm.

### Examples B: Tert.-Amine neutralized conductive polymers

### Example 15 : Neutralization of conductive (polypyrrole coated) core/shell nanoparticles with triethylamine.

To 10 g of dispersion from Ex. 3 (solid content 3.5 %) 0.1 M solution of triethylamine in methanol is added dropwise with stirring until pH of dispersion reaches 5.0 (ca. 3.2 mL). Methanol is removed by evaporation to give 9.1 g dispersion with a solid content of 4.2 %, which is adjusted to 2 % by adding de-ionized water.
Analytics: Elemental analysis; found %: N 5.57, S 5.41

### Example 16 : Neutralization of conductive (polypyrrole coated) core/shell nanoparticles with diisopropylethylamine.

Produced analogously to Ex. 15, replacing triethylamine with diisopropylethylamine. Analytics: Elemental analysis; found %: N 5.42, S 5.32. AFM roughness of a spin-coated film is detected as described in example 3; result: Rq = 11 nm.

### Example 17 : Neutralization of conductive (polypyrrole coated) core/shell nanoparticles with tributylamine.

Produced analogously to Ex. 15, replacing triethylamine with tributylamine.
Analytics: Elemental analysis; found %: N 5.20, S 5.10.

### Example 18 : Neutralization of conductive (polypyrrole coated) "shell only" nanoparticles with triethylamine.

To 10.5 g of dispersion from Ex. 10 (solid content 2.0 %) 0.1 M solution of triethylamine in methanol is added dropwise with stirring until pH of dispersion reaches 5.0 (ca. 3.6 mL). Dispersion is diluted with water (10 mL), methanol is removed by evaporation to give 7.0 g dispersion with a solid content of 2.3 %.

### Example 19 : Neutralization of conductive (polypyrrole coated) "shell only" nanoparticles with tributylamine.

Produced analogously to Ex. 18, replacing triethylamine with tributylamine.
Analytics: Elemental analysis; found %: N 5.20, S 5.10.

### Example 20 : Neutralization of commercial PEDOT-PSS blend (Clevios^{®} P VP Al 4083; supplier: H.C. Starck) with triethylamine.

To 7.0 g of the PEDOT:PSS dispersion (solid content ca. 1.5 %) 0.1 M solution of triethylamine in methanol is added dropwise with stirring until pH of dispersion reaches 7.0 (ca. 3.9 mL). Dispersion is diluted with water (10 mL), methanol is removed by evaporation to give 7.0 g dispersion with a solid content of 2.0 %.

### Example 21 : Neutralization of commercial PEDOT-PSS blend (Clevios^{®} P VP Al 4083, supplied by H.C. Starck) with tributylamine. The sample is produced analogously to Ex. 20, replacing triethylamine with tributylamine.

### Examples C: OLED Device Performance

Preparation of light emitting devices (OLED's): Glass substrates with patterned ITO are cleaned with acetone, propanol and water in an ultrasonic bath. The dried substrates are treated with oxygen plasma for 2 min. The dispersion of the conductive polymer of examples A or B is spin-coated (5000 rpm) to obtain a film thickness of ca. 70 nm. A further reference (sample R) is prepared in analogous manner (1500 rpm, 70 nm) but using acidic PEDOT:PSS Clevios^{®} P VP Al 4083 (supplier: H.C. Starck) instead.

The films are dried on a hot plate (10 min., 200 °C, ambient atmosphere). Under nitrogen, a blue emitting Super Yellow (SY from Merck) is spin-coated on top with a layer thickness of 80 nm (=emissive layer). The devices are finished by evaporation of a bilayer cathode consisting of 5 nm Ba and 70 nm Al. Results are compiled in the following table.

**Table: Efficiency at 1000 cd/m² of OLED**

| Conductor of Example | No. Neutralization | Efficiency (cd/A) at 1000 cd/m² |
|---|---|---|
| | | |
| 3 | none (comparison) | 8.75 |
| 4 | none (comparison) | 9.4 |
| 6 | none (comparison) | 8.0 |
| 8 | none (comparison) | 7.5 |
| 10 (invention) | none | 8.5 |
| 11 (invention) | none | 9.75 |
| 20 | NEt₃ (invention) | 12.0 |
| 21 | NBu₃ (invention) | 11.5 |
| 15 | NEt₃ (invention) | 9.5 |
| 16 | diisopropyl ethylamine (inv.) | 9.0 |
| 17 | NBu₃ (invention) | 9.0 |
| 12 (invention) | none | 13.0 |
| PEDOT:PSS | none (comparison) | 12.0 |

The results show that the conductive polymers neutralized according to the present invention lead to an OLED luminiscence and efficacy as good as with the acidic form, while neutralization with alkali hydroxide results in poor device performance.

The present neutralized polymers further may result in a lower roughness of the conductive layer (see examples 3 and 16).

## Claims

1. Process for the preparation of an electronic device comprising a layer of a conductive (co)polymer or blend wherein anionic polysulfonate moieties are combined with cationic moieties selected from polythiophenes, polypyrroles and/or polyanilines, which process comprises addition of a tertiary amine to the aqueous solution or dispersion of the polymer's acidic form, and application of the thus neutralized polymer or polymer blend by a suitable method to form a layer.

2. Process of claim 1 for the preparation of an organic field effect transistor, a solar cell, an organic light emitting diode, an organic photodiode, or a device comprising an organic field effect transistor, solar cell, organic light emitting diode and/or organic photodiode.

3. Process according to claim 1 or 2, wherein the tertiary amine is added to the aqueous solution to pH 4 - 7.

4. Process according to any of claims 1 - 3, wherein the neutralized solution or dispersion obtained is subsequently dried, and optionally redissolved or dispersed in an organic solvent, especially of boiling point 50-180°C.

5. Process according to any of claims 1 - 4, wherein the tertiary amine is selected from amines of the formula NR₃, where R is selected from C₁-C₈alkyl, C₂-C₆alkyl substituted by OH or C₁-C₆alkoxy or di(C₂-C₆alkyl)amino-C₂-C₆alkyl, phenyl, benzyl, tolyl, especially from C₂-C₆alkyl such as ethyl, n-propyl, n-butyl.

6. Process according to any of claims 1 - 5, wherein the aqueous solution or dispersion of the polymer is desalinated by a step comprising ion exchange and/or dialysis prior to the neutralization step.

7. Process according to any of claims 1 - 6, wherein the method to form a layer is selected from printing and spin-coating.

8. Process according to any of claims 1 - 7, wherein the conductive (co)polymer or blend containing anionic polysulfonate moieties combined with cationic moieties selected from polythiophenes, polypyrroles and/or polyanilines has been obtained by oxidative polymerization of pyrrole, aniline or 3,4-ethylenedioxythiophene in presence of a copolymer comprising 10 to 70 % b.w. of structural units derived from a polyethylenglycol-acrylate or polyethylenglycol-methacrylate having free or methylated end groups, and 30 to 90 % b.w. of structural units derived from styrene sulfonate or styrene sulfonic acid.

9. Electronic device comprising a layer of a conductive polymer or polymer blend wherein anionic polysulfonate moieties are combined with cationic moieties selected from polythiophenes, polypyrroles and/or polyanilines, **characterized in that** excess sulfonate ions essentially are counterbalanced by tertiary ammonium ions.

10. Electronic device of claim 9, which is an organic field effect transistor, a solar cell, an organic light emitting device, an organic photodiode, or a device comprising an organic field effect transistor, solar cell, organic light emitting diode and/or organic photodiode.

11. Use of a conductive polymer or polymer blend wherein anionic polysulfonate moieties are combined with cationic moieties selected from polythiophenes, polypyrroles and/or polyanilines, and excess sulfonate ions essentially are counterbalanced by tertiary ammonium ions, for the preparation of an electronic device, especially an organic field effect transistor, a solar cell, an organic light emitting diode, an organic photodiode.

12. Use according to claim 11 for the preparation of an organic light emitting diode.

13. Water soluble conductive copolymer or blend comprising anionic polysulfonate moieties and cationic moieties selected from polythiophenes, polyanilines and/or polypyrroles, whose anionic part is a copolymer combining sulfonic recurring structural units derived from vinylbenzenesulfonic, C₂-C₈alkenylsulfonic, (meth)acryloyloxy-C₂-C₈alkyl-sulfonic, (meth)acryloylamido-C₂-C₈alkyl-sulfonic acid or salts or mixtures thereof, with at least 10% b.w. recurring structural units of polyethylenglycol-acrylate and/or polyethylenglycol-methacrylate.

14. Conductive copolymer or blend according to claim 13, whose cationic part is selected from poly(3,4-ethylenedioxythiophene), polyanilines or polypyrrole, especially polypyrrole, and whose anionic part is a copolymer comprising as monomer units 10 to 70 % b.w. of polyethylenglycol-acrylate and/or polyethylenglycol-methacrylate and 10 to 90 % b.w. of vinylbenzenesulfonic, C₂-C₈alkenylsulfonic, (meth)acryloyloxy-C₂-C₈alkylsulfonic, (meth)acryloylamido-C₂-C₈alkyl-sulfonic moieties, and whose molecular weight Mn is preferably from the range 10'000 to 200'000 Da as determined by size exclusion chromatography.

15. Conductive copolymer or blend according to claim 13 or 14 containing cationic species balancing more than 1% of the total sulfonate charge, which are exclusively selected from the group consisting of the cationic polymer, H+, Fe2+, Fe3+, alkali+, Ca2+, Zn2+, Mg2+, Al3+ and ammonium, especially exclusively selected from the group consisting of the cationic polymer, H+ and, most preferably, tertiary ammonium, where tertiary ammonium is most preferably HNR₃+ with R as defined in claim 5.
